(19) Europäisches Patentamt
European Patent Office
Office européen des brevets

(11) **EP 3 794 359 B1**

(12) **EUROPÄISCHE PATENTSCHRIFT**

(45) Veröffentlichungstag und Bekanntmachung des Hinweises auf die Patenterteilung:
**03.05.2023 Patentblatt 2023/18**

(21) Anmeldenummer: **19795098.3**

(22) Anmeldetag: **15.10.2019**

(51) Internationale Patentklassifikation (IPC):
*G01R 22/10* (2006.01)   *B60L 53/18* (2019.01)
*B60L 53/60* (2019.01)   *H02J 7/00* (2006.01)
*G01R 35/04* (2006.01)   *G01R 31/58* (2020.01)

(52) Gemeinsame Patentklassifikation (CPC):
**G01R 22/10; B60L 53/18; B60L 53/60; H02J 7/0047;** G01R 31/58; G01R 35/04; Y02T 10/70; Y02T 10/7072; Y02T 90/12; Y02T 90/14; Y02T 90/16

(86) Internationale Anmeldenummer:
**PCT/EP2019/077867**

(87) Internationale Veröffentlichungsnummer:
**WO 2020/078950 (23.04.2020 Gazette 2020/17)**

(54) **STROMZÄHLER UND ZUGEHÖRIGES BETRIEBSVERFAHREN**

ELECTRIC METER AND CORRESPONDING OPERATING METHOD

COMPTEUR DE COURANT ET PROCÉDÉ DE FONCTIONNEMENT ASSOCIÉ

(84) Benannte Vertragsstaaten:
**AL AT BE BG CH CY CZ DK EE ES FI FR GB GR HR HU IE IS IT LI LT LU LV MC MK MT NL NO PL PT RO RS SE SI SK SM TR**

(30) Priorität: **16.10.2018 DE 102018125597**

(43) Veröffentlichungstag der Anmeldung:
**24.03.2021 Patentblatt 2021/12**

(73) Patentinhaber: **Isabellenhütte Heusler GmbH & Co. KG**
**35683 Dillenburg (DE)**

(72) Erfinder:
• **LEPPER, Andreas**
 **35644 Hohenahr (DE)**
• **POLLMANN, Michael**
 **35689 Dillenburg (DE)**

(74) Vertreter: **v. Bezold & Partner Patentanwälte - PartG mbB**
**Ridlerstraße 57**
**80339 München (DE)**

(56) Entgegenhaltungen:
EP-A1- 2 579 417       DE-A1-102012 102 633
DE-A1-102014 226 397   US-A1- 2012 112 735
US-A1- 2013 300 429    US-B1- 10 084 266

**Beschreibung**

Die Erfindung betrifft einen Stromzähler zur elektrischen Verbrauchsmessung an einem elektrischen Verbraucher, beispielsweise bei einem Ladevorgang eines Elektroautos. Weiterhin umfasst die Erfindung ein entsprechendes Betriebsverfahren.

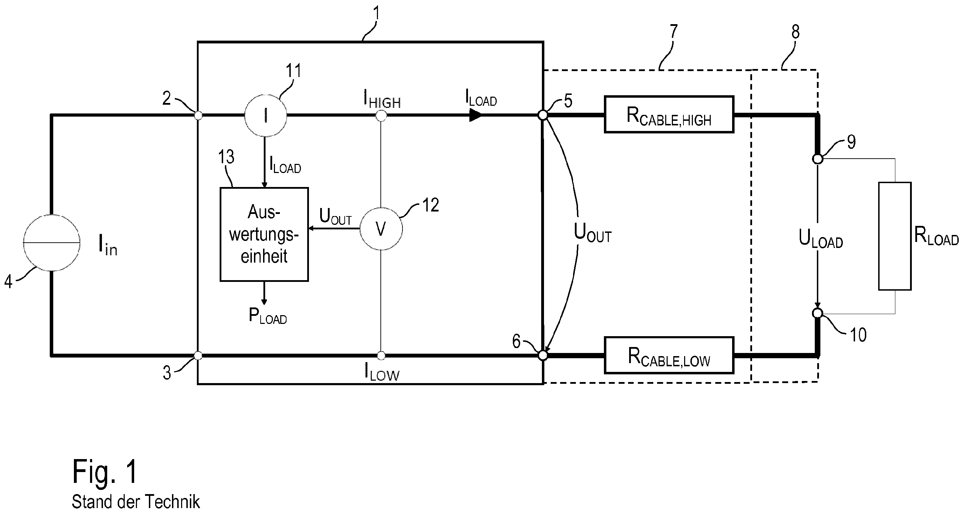

Aus dem Stand der Technik sind Stromzähler bekannt, die beispielsweise bei einem Ladevorgang eines Elektroautos eingesetzt werden, um die bei einem Ladevorgang entnommene elektrische Leistung zu messen, was für eine Verbrauchsabrechnung erforderlich ist. Figur 1 zeigt eine schematische Darstellung eines solchen bekannten Stromzählers 1, der eingangsseitig über einen High-Side-Stromanschluss 2 und einen Low-Side-Stromanschluss 3 mit einer Ladequelle 4 verbunden ist, die hier nur schematisch dargestellt ist. Ausgangsseitig weist der Stromzähler ebenfalls einen High-Side-Stromanschluss 5 und einen Low-Side-Stromanschluss 6 auf, wobei der High-Side-Stromanschluss 5 und der Low-Side-Stromanschluss 6 über ein Ladekabel 7 mit einem Stecker 8 mit einem elektrischen Verbraucher $R_{LOAD}$ verbunden sind. Der Stecker 8 weist hierbei zwei Anschlüsse 9, 10 auf, die einen Übergabepunkt zu dem Verbraucher $R_{LOAD}$ definieren. In dem Ladekabel 7 verläuft an der High-Side eine Ladeleitung $R_{CABLE,HIGH}$ und an der Low-Side eine Ladeleitung $R_{CABLE,LOW}$. Bei einem Ladevorgang fließt ein Ladestrom $I_{LOAD}$ durch das Ladekabel 7 zu dem Verbraucher $R_{LOAD}$, um beispielsweise eine wiederaufladbare Batterie in einem Elektroauto aufzuladen. Der Ladestrom $I_{LOAD}$ wird in dem Stromzähler 1 durch eine Strommesseinrichtung 11 gemessen, wobei die Strommesseinrichtung 11 den Ladestrom $I_{LOAD}$ beispielsweise mittels eines niederohmigen Strommesswiderstands ("Shunt") messen kann. Darüber hinaus enthält der Stromzähler 1 eine Spannungsmesseinrichtung 12, die eine Ausgangsspannung $U_{OUT}$ zwischen High-Side und Low-Side innerhalb des Stromzählers 1 misst. Eine Auswertungseinheit 13 berechnet dann aus dem gemessenen Ladestrom $I_{LOAD}$ und der gemessenen Ausgangsspannung $U_{OUT}$ die Ladeleistung $P_{LOAD}$, die für eine Verbrauchsabrechnung herangezogen werden kann.

Problematisch an diesem bekannten Messprinzip ist die Tatsache, dass die Leitungsverluste in dem Ladekabel 7 nicht unmittelbar berücksichtigt werden, so dass die tatsächliche Ladeleistung $P_{LOAD}$ an dem durch die beiden Anschlüsse 9, 10 des Steckers 8 gebildeten Übergabepunkt kleiner ist als die von der Auswertungseinheit 13 berechnete Ladeleistung $P_{LOAD}$.

Theoretisch besteht zwar die Möglichkeit einer rechnerischen kompensatorischen Berücksichtigung der Leitungsverluste in den Ladeleitungen $R_{CABLE,HIGH}$, $R_{CABLE,LOW}$. Dies setzt aber voraus, dass die wesentlichen Leitungsparameter (z. B. Leitungslänge, Leitungsquerschnitt, spezifische elektrische Leitfähigkeit des Leitungsmaterials) bekannt sind, was nicht immer der Fall ist. Diese rechnerische Berücksichtigung der Leitungsverluste durch eine parametrisierte Messwertkompensation ist also nur in bestimmen Fällen möglich.

Weiterhin denkbar ist eine Berücksichtigung der Leitungsverluste durch eine Vierleitermessung, indem die Ladespannung direkt an dem Übergabepunkt in dem Stecker gemessen wird. Dies setzt jedoch voraus, dass entsprechende Messleitungen vorhanden sind, die eine Spannungsmessung an dem Übergabepunkt ermöglichen. Bei einer Nachrüstung von bestehenden Systemen ist dies jedoch oftmals nicht der Fall.

Zum technischen Hintergrund der Erfindung ist auch hinzuweisen auf DE 10 2012 102633 A1, DE 10 2014 226397 A1, US 10 084 266 B1, US 2012/112735 A1 und EP 2 579 417 A1.

Schließlich offenbart US 2013/300429 A1 einen Stromzähler gemäß dem Oberbegriff von Anspruch 1 und ein Betriebsverfahren gemäß dem Oberbegriff von Anspruch 10. Hierbei sind zwei Betriebsarten möglich, nämlich zum einen ein Messbetrieb und zum anderen ein Diagnosebetrieb, wobei im Diagnosebetrieb auch Leitungsverluste berücksichtigt werden. In dem eigentlichen Messbetrieb werden hierbei jedoch keine Leitungsverluste berücksichtigt.

Der Erfindung liegt deshalb die Aufgabe zugrunde, einen entsprechend verbesserten Stromzähler zu schaffen.

Diese Aufgabe wird durch einen Stromzähler bzw. ein entsprechendes Betriebsverfahren gemäß den Nebenansprüchen gelöst.

Der erfindungsgemäße Stromzähler weist zunächst in Übereinstimmung mit dem eingangs beschriebenen bekannten Stromzähler einen Stromausgang auf, insbesondere mit zwei Stromanschlüssen an der High-Side und an der Low-Side, um ein Verbindungskabel anzuschließen, das zu einem Übergabepunkt führt, insbesondere in einem Stecker des Verbindungskabels, wobei der Verbraucher über das Verbindungskabel an dem Übergabepunkt mit einem elektrischen Strom gespeist wird.

Vorzugsweise handelt es sich bei dem Verbindungskabel um ein Ladekabel, wobei der Stecker des Ladekabels beispielsweise an ein Elektroauto angeschlossen werden kann, um das Elektroauto aufzuladen. Alternativ besteht jedoch die Möglichkeit, dass das Elektroauto selbst ein Ladekabel mit einem Stecker aufweist, der dann an den Stromausgang des Stromzählers angeschlossen wird.

Weiterhin umfasst der erfindungsgemäße Stromzähler in Übereinstimmung mit dem eingangs beschriebenen bekannten Stromzähler eine Messschaltung, um mindestens eine elektrische Verbrauchsgröße des über den Stromausgang zu dem Verbraucher fließenden Stroms zu messen.

Der erfindungsgemäße Stromzähler zeichnet sich nun dadurch aus, dass er wahlweise in einer von mehreren Betriebsarten betreibbar ist, wobei sich die Betriebsarten durch die Berücksichtigung der Leitungsverluste in dem Verbindungskabel unterscheiden. Der Stromzähler kann dann vorzugsweise selbstständig die geeignete Betriebsart auswählen und zwar vorzugsweise in Abhängigkeit davon, ob eine Vierleitermessung möglich ist und ob Leitungsdaten des Verbindungskabels gespeichert sind, die eine parametrisierte Messwertkompensation der Leitungsverluste ermöglichen.

Gemäß der Erfindung weist der Stromzähler zunächst eine erste Betriebsart auf, in der der Stromzähler die Leitungsverluste in dem Verbindungskabel zu dem Verbraucher durch eine Vierleitermessung direkt an dem Übergabepunkt zu dem Verbraucher berücksichtigt, nämlich zum einen durch eine Spannungsmessung an dem Übergabepunkt und zum anderen durch eine Strommessung in dem Stromzähler.

Hierzu weist die Messschaltung in dem Stromzähler vorzugsweise zunächst einen ersten Spannungsmesseingang auf, um eine erste Spannung direkt an dem Übergabepunkt zu dem Verbraucher gegenüber einem Referenzpotential zu messen. Vorzugsweise ist das Referenzpotential hierbei das Potential der High-Side in dem Stromzähler. Die Messung dieser ersten Spannung erfolgt vorzugsweise über eine Messleitung in dem Verbindungskabel, wobei die Messleitung einerseits an den ersten Spannungsmesseingang der Messschaltung und andererseits an den Übergabepunkt angeschlossen ist, um die Spannung an dem Übergabepunkt zu messen. Vorzugsweise erfolgt die Messung dieser ersten Spannung an der High-Side an dem Übergabepunkt.

Darüber hinaus weist die Messschaltung vorzugsweise einen zweiten Spannungsmesseingang auf, um eine zweite Spannung direkt an dem Übergabepunkt zu dem Verbraucher zu messen und zwar vorzugsweise an der Low-Side. Die zweite Spannung wird vorzugsweise gegenüber demselben Referenzpotential gemessen, nämlich vorzugsweise gegenüber dem Potential der High-Side in dem Stromzähler. Die Messung der zweiten Spannung erfolgt ebenfalls vorzugsweise durch eine Messleitung, die in dem Verbindungskabel verläuft und von dem zweiten Spannungsmesseingang zu dem Messpunkt an dem Übergabepunkt verläuft und zwar vorzugsweise an der Low-Side des Übergabepunkts.

Ferner weist die Messschaltung vorzugsweise einen dritten Spannungsmesseingang auf, um eine dritte Spannung in den Stromzähler zu messen und zwar vorzugsweise zwischen der High-Side und der Low-Side in dem Stromzähler.

Darüber hinaus weist der erfindungsgemäße Stromzähler in Übereinstimmung mit dem Stand der Technik vorzugsweise eine Strommesseinrichtung auf, um den Ausgangsstrom zu messen, der zu dem Verbraucher fließt. Diese Strommesseinrichtung kann beispielsweise gemäß der Vierleitertechnik arbeiten und einen niederohmigen Strommesswiderstand ("Shunt") aufweisen, wie es aus dem Stand der Technik hinlänglich gekannt ist und deshalb nicht weiter beschrieben werden muss. Die Strommesseinrichtung kann jedoch zur Messung des Ausgangsstroms grundsätzlich auch andere Messprinzipien anwenden.

Darüber hinaus weist der erfindungsgemäße Stromzähler eine Recheneinheit auf, welche die Leitungsverluste in dem Verbindungskabel in der ersten Betriebsart gemäß der Vierleitertechnik berechnet und zwar in Abhängigkeit von folgenden Messgrößen:

- Messwert der ersten Spannung,
- Messwert der zweiten Spannung,
- Messwert der dritten Spannung, und
- Messwert des Ausgangsstroms.

Diese Berechnung kann nach folgender Formel erfolgen:

$$P_{VERLUST} = I_{Load} \cdot (U3 - U2 + U1).$$

mit:

$I_{LOAD}$:  Ausgangsstrom durch das Verbindungskabel,
U1:  Spannung an dem Übergabepunkt an der High-Side,
U2:  Spannung an dem Übergabepunkt an der Low-Side,
U3:  Spannung in dem Stromzähler zwischen High-Side und Low-Side.

Darüber hinaus kann der erfindungsgemäße Stromzähler auch in einer zweiten Betriebsart betrieben werden, in der die Leitungsverluste nicht gemäß der Vierleitertechnik berücksichtigt werden, wie vorstehend beschrieben wurde. Stattdessen werden die Leitungsverluste in der Verbindungsleitung in der zweiten Betriebsart durch eine parametrisierte Berechnung der Leitungsverluste berücksichtigt. Dies setzt voraus, dass die relevanten Leitungsparameter (z. B. Länge des Verbindungskabels, spezifische elektrische Leitfähigkeit des Materials des Verbindungskabels, Leitungsquerschnitt des Verbindungskabels) in einem Parameterspeicher des Stromzählers hinterlegt sind. Die Recheneinheit in dem Stromzähler kann dann den Leitungswiderstand und/oder die Leitungsverluste in dem Verbindungskabel in Abhängigkeit von dem gemessenen Strom einerseits und den gespeicherten Leitungsparametern andererseits berechnen. Diese Berechnung der Verlustleistung in dem Verbindungskabel kann nach folgender Formel erfolgen:

$$P_{VERLUST} = I_{LOAD}^2 \cdot 2 \cdot L/(\sigma \cdot A).$$

mit:

$I_{LOAD}$:  Ausgangsstrom durch das Verbindungskabel,
L:  Einfache Länge des Verbindungskabels,
A:  Leitungsquerschnitt des Verbindungskabels,
$\sigma$:  spezifische elektrische Leitfähigkeit des Leitungsmaterials des Verbindungskabels.

Die beiden vorstehend beschriebenen Betriebsarten sind jedoch nicht möglich, wenn in dem Parameterspeicher keine Leitungsparameter hinterlegt sind und wenn auch keine Vierleitermessung gemäß der ersten Betriebsart möglich ist. Der Stromzähler ist deshalb vorzugsweise auch in einer dritten Betriebsart betreibbar, in der die Leitungsverluste in dem Verbindungskabel zu dem Verbraucher gar nicht berücksichtigt werden.

Die vorstehend beschriebenen drei Betriebsarten werden priorisiert in dem Sinne, dass vorzugsweise die erste Betriebsart ausgewählt wird, sofern eine Vierleitermessung an dem Übergabepunkt möglich ist. Ersatzweise wird dann die zweite Betriebsart ausgewählt, wenn Leitungsparameter in dem Parameterspeicher hinterlegt sind. Die dritte Betriebsart wird dann nur ausgewählt, wenn weder eine Vierleitermessung möglich ist noch Leitungsparameter in dem Parameterspeicher hinterlegt sind.

Die Auswahl der Betriebsart erfolgt vorzugsweise durch eine Auswahleinrichtung in dem Stromzähler. Die Auswahleinrichtung ermittelt, ob an die Spannungsmesseingänge des Stromzählers Messleitungen angeschlossen sind und wählt gegebenenfalls die erste Betriebsart aus. Weiterhin ermittelt die Auswahleinrichtung vorzugsweise, ob in dem Parameterspeicher Leitungsparameter gespeichert sind und wählt die zweite Betriebsart aus, wenn keine Messleitungen an die Spannungsmesseingänge angeschlossen sind, so dass keine Vierleitermessung möglich ist, sofern aber in dem Parameterspeicher Leitungsparameter gespeichert sind, was eine parametrisierte Messwertkompensation der Leistungsverluste ermöglicht. Die Auswahleinrichtung wählt dagegen die dritte Betriebsart aus, wenn weder eine Vierleitermessung möglich ist noch Leitungsparameter in dem Parameterspeicher gespeichert sind.

In dem bevorzugten Ausführungsbeispiel der Erfindung vergleicht die Auswahleinrichtung die innerhalb des Stromzählers gemessene Ausgangsspannung an dem Stromausgang mit der direkt an dem Übergabepunkt gemessenen Ausgangsspannung. Die Auswahleinrichtung wählt dann die erste Betriebsart mit der Vierleitermessung aus, wenn die Differenz zwischen den beiden Ausgangsspannungen innerhalb eines vorgegebenen Toleranzbereichs liegt, da dies darauf hindeutet, dass Messleitungen für eine Vierleitermessung angeschlossen sind. Falls dagegen keine Messleitungen zur Vierleitermessung angeschlossen sind, so wird an den Spannungsmesseingängen des Stromzählers auch keine Spannung gemessen, so dass die Differenz zwischen den beiden Ausgangsspannungen relativ groß ist, was anzeigt, dass keine Vierleitermessung möglich ist.

Darüber hinaus prüft die Auswahleinrichtung, ob in dem Parameterspeicher Leitungsparameter hinterlegt sind. Die Auswahleinrichtung wählt dann die zweite Betriebsart mit der parametrisierten Berechnung der Leitungsverluste aus, falls die Differenz zwischen den beiden Ausgangsspannungen nicht innerhalb des vorgegebenen Toleranzbereichs liegt und somit keine Vierleitermessung möglich ist, und falls in dem Parameterspeicher Leitungsparameter hinterlegt sind.

Andernfalls wählt die Auswahleinrichtung dagegen die dritte Betriebsart aus, in der die Leitungsverluste überhaupt nicht berücksichtigt werden. Diese Auswahl der dritten Betriebsart erfolgt, sofern die Differenz zwischen den beiden Ausgangsspannungen nicht innerhalb des vorgegebenen Toleranzbereichs liegt und wenn in dem Parameterspeicher keine Leitungsparameter hinterlegt sind.

Weiterhin ist zu erwähnen, dass die Erfindung nicht nur Schutz beansprucht für einen Stromzähler als einzelnes Bauteil. Vielmehr beansprucht die Erfindung auch Schutz für ein Stromzählersystem mit dem erfindungsgemäßen Stromzähler und einem Verbindungskabel, wobei das Verbindungskabel die beiden Messleitungen enthält, welche die Spannungsmessung direkt an dem Übergabepunkt ermöglichen.

Schließlich umfasst die Erfindung auch ein entsprechendes Betriebsverfahren für einen Stromzähler, wobei sich die einzelnen Verfahrensschritte des erfindungsgemäßen Betriebsverfahrens aus der vorstehenden Beschreibung der Funktionsweise des erfindungsgemäßen Stromzählers ergeben und deshalb nicht separat beschrieben werden müssen.

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung anhand der Figuren näher erläutert. Es zeigen:

Figur 1 eine schematische Darstellung eines herkömmlichen Stromzählersystems,

Figur 2 eine schematische Darstellung eines erfindungsgemäßen Stromzählersystems,

Figur 3 eine schematische Darstellung der Auswertungseinheit in dem erfindungsgemäßen Stromzähler gemäß Figur 2, sowie

Figur 4 ein Flussdiagramm zur Verdeutlichung des Betriebsverfahrens des erfindungsgemäßen Stromzählers.

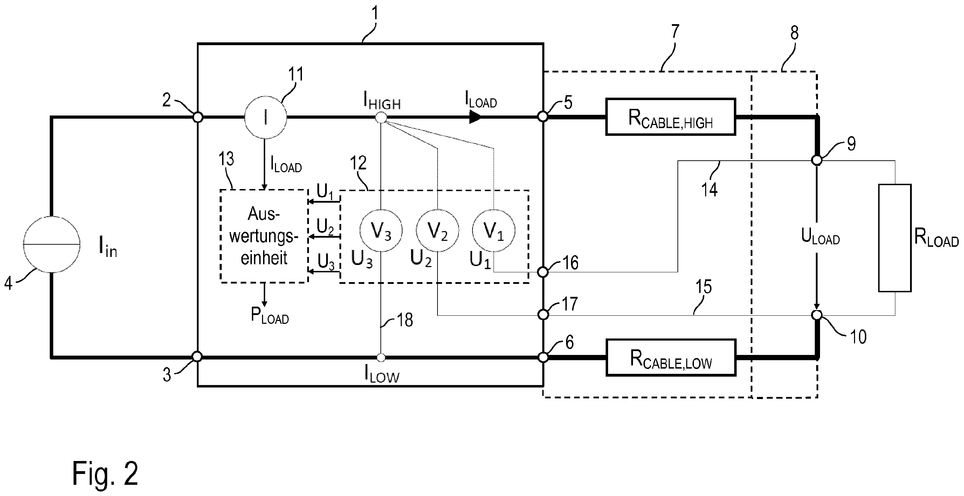

Im Folgenden wird nun das erfindungsgemäße Ausführungsbeispiel gemäß Fig. 2 beschrieben, das teilweise mit dem eingangs beschriebenen und in Fig. 1 gezeigten herkömmlichen System übereinstimmt, so dass zur Vermeidung von Wiederholungen auf die vorstehende Beschreibung verwiesen wird, wobei für entsprechende Einzelheiten dieselben Bezugszeichen verwendet werden.

Eine Besonderheit besteht nun darin, dass in dem Ladekabel 7 zwei Messleitungen 14, 15 verlaufen, die eine Spannungsmessung direkt an dem Übergabepunkt ermöglichen, der durch die beiden Anschlüsse 9, 10 des Steckers 8 gebildet wird. Die Messleitung 14 ermöglicht hierbei eine Spannungsmessung an der High-Side an dem Anschluss 9 des Steckers 8, während die andere Messleitung 15 eine Spannungsmessung in dem Anschluss 10 des Steckers 8 an der Low-Side ermöglicht.

Alternativ besteht jedoch auch die Möglichkeit, dass die Messleitungen 14, 15 außerhalb des Ladekabels 7 verlaufen, beispielsweise in einem separaten Messkabel.

Darüber hinaus besteht die Möglichkeit, dass die Messleitungen 14, 15 überhaupt nicht konnektiert sind, wie es beispielsweise bei einer Nachrüstung bestehender Systeme der Fall sein kann. In diesem Fall ist keine Vierleitermessung an dem Übergabepunkt möglich, so dass die Leitungsverluste auch nicht gemäß der Vierleitertechnik messtechnisch kompensiert werden können. Stattdessen werden die Leitungsverluste dann durch eine parametrisierte Messwertkompensation berücksichtigt, wie noch detailliert beschrieben wird.

Zur Abfrage der beiden Messleitungen 14, 15 in der ersten Betriebsart mit der Berücksichtigung der Leitungsverluste gemäß der Vierleitertechnik weist der Stromzähler 1 zwei Spannungsmessanschlüsse 16, 17 auf.

Die Spannungsmesseinrichtung 12 enthält zwei Spannungsmesser V1, V2, wobei der Spannungsmesser V1 eine Spannung U1 an dem Anschluss 9 des Steckers 8 an der High-Side misst und zwar in Bezug auf ein Referenzpotential, das durch die High-Side an dem Stromanschluss 5 gebildet wird.

Darüber hinaus weist die Spannungsmesseinrichtung 12 einen Spannungsmesser V2 auf, der eine Spannung U2 an dem anderen Anschluss 10 des Steckers 8 an der Low-Side misst und zwar ebenfalls gegenüber dem Referenzpotential an dem Stromanschluss 5 an der High-Side des Stromzählers 1. Ferner weist die Spannungsmesseinrichtung 12 einen dritten Spannungsmesser V3 auf, der über eine Messleitung 18 eine Spannung U3 zwischen High-Side und Low-Side in dem Stromzähler 1 misst.

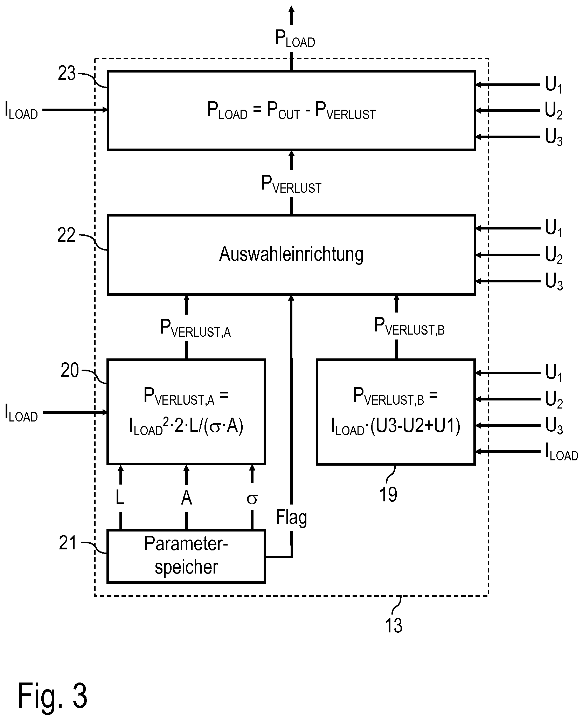

Die drei Spannungen U1, U2, U3 werden an die Auswertungseinheit 13 weitergeleitet, die in Fig. 3 schematisch dargestellt ist.

Zum einen berechnet eine Recheneinheit 19 in der Auswertungseinheit 13 die Leitungsverluste $P_{VER\text{-}LUST,B}$ in dem Ladekabel 7 gemäß der Vierleitertechnik nach folgender Formel:

$$P_{VERLUST,B} = I_{LOAD} \cdot (U3 - U2 + U1),$$

mit:

$I_{LOAD}$:    Ausgangsstrom durch das Ladekabel 7,
U1:    Spannung an dem Übergabepunkt an der High-Side, d.h. an dem Anschluss 9,
U2:    Spannung an dem Übergabepunkt an der Low-Side, d.h. an dem Anschluss 10,
U3:    Spannung in dem Stromzähler 1 zwischen High-Side und Low-Side.

Zum anderen berechnet eine Recheneinheit 20 in der Auswertungseinheit 13 die Leitungsverluste $P_{VERLUST,A}$ in dem Ladekabel 7 in Abhängigkeit von hinterlegten Leitungsparametern nach folgender Formel:

$$P_{VERLUST,A} = I_{LOAD}^2 \cdot 2 \cdot L/(\sigma \cdot A),$$

mit:

$I_{LOAD}$:    Ausgangsstrom durch das Ladekabel 7,
L:    Einfache Länge des Ladekabels 7,
A:    Leitungsquerschnitt des Ladekabels 7,
$\sigma$:    spezifische elektrische Leitfähigkeit des Leitungsmaterials des Ladekabels 7.

Die Recheneinheit 20 bezieht die Leitungsparameter hierbei aus einem Parameterspeicher 21, in dem die Leitungsparameter hinterlegt sind. Der Parameterspeicher 21 überträgt hierbei ein Flag an eine Auswahleinrichtung 22, das angibt, ob in dem Parameterspeicher 21 die Leitungsparameter hinterlegt sind. Die Auswahleinrichtung 22 weiß also, ob in dem Parameterspeicher 21 Leitungsparameter hinterlegt sind, was für eine parametrisierte Messwertkompensation der Leitungsverluste erforderlich ist.

Darüber hinaus vergleicht die Auswahleinrichtung 22 die Ausgangsspannung $U_{OUT}$ am Ausgang des Stromzählers 1 mit der Ladespannung $U_{LOAD}$ am Übergabepunkt, die gemäß der Vierleitertechnik gemessen wird. Falls beide Spannungen innerhalb eines vorgegebenen Toleranzbereichs liegen, so weiß die Auswahleinrichtung 22, dass die Leitungsverluste gemäß der Vierleitertechnik berücksichtigt werden können. Die Auswahleinrichtung 22 wählt dann die erste Betriebsart aus, in der die Leitungsverluste gemäß der Vierleitertechnik berücksichtigt werden. Hierbei kann die Auswahleinrichtung 22 dann die Leitungsverluste $P_{VERLUST,B}$ übernehmen, die von der Recheneinheit 19 berechnet wurden.

Falls die Differenz zwischen den beiden Spannungen $U_{OUT}$ und $U_{LOAD}$ dagegen nicht innerhalb des vorgegebenen Toleranzbereichs liegen, so weiß die Auswahleinrichtung 22, dass keine Vierleitermessung an dem Übergabepunkt möglich ist.

In diesem Fall überprüft die Auswahleinrichtung 22 weiter, ob von dem Parameterspeicher 21 ein Flag gesendet wird, das anzeigt, dass in dem Parameterspeicher 21 Leitungsparameter hinterlegt sind. Falls dies der Fall ist, so wählt die Auswahleinrichtung 22 die zweite Betriebsart aus, in der die Leitungsverluste in dem Ladekabel 7 durch eine parametrisierte Messwertkompensation berücksichtigt werden. Die Auswahleinrichtung 22 wählt dann die Verlustleistung $P_{VERLUST,A}$ aus, die von der Recheneinheit 20 berechnet wurde.

Falls die Auswahleinrichtung 22 dagegen kein Flag von dem Parameterspeicher 21 empfängt, weil in dem Parameterspeicher 21 keine Leitungsparameter hinterlegt sind, so wählt die Auswahleinrichtung 22 die dritte Betriebsart aus, in der die Leitungsverluste $P_{VERLUST}$ als Null angenommen werden.

Eine Recheneinheit 23 berechnet dann die Ausgangsleistung $P_{LOAD}$ an dem Übergabepunkt zwischen den beiden Anschlüssen 9, 10 in Abhängigkeit von der Ausgangsleistung $P_{OUT}$ am Ausgang des Stromzählers 1 und der Verlustleistung $P_{VERLUST}$.

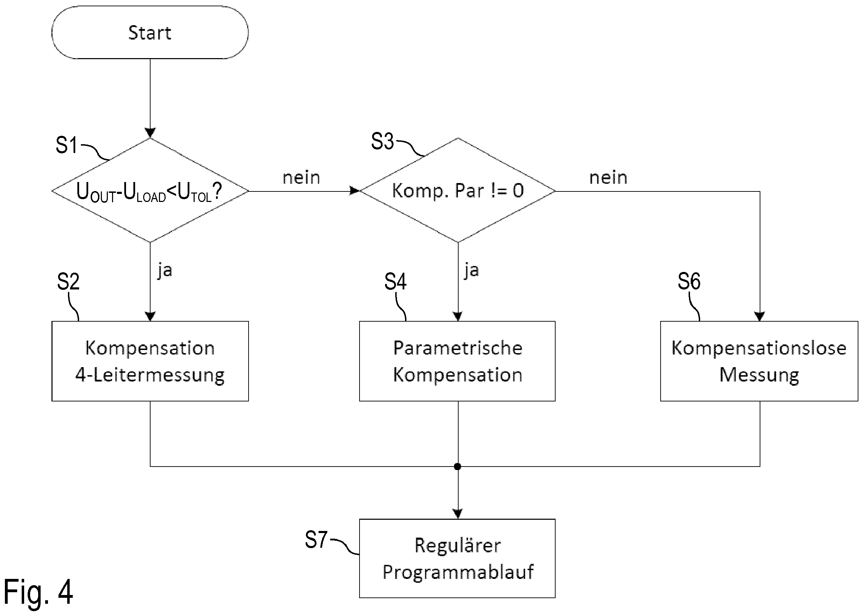

Fig. 4 zeigt die Betriebsweise des erfindungsgemäßen Stromzählers in Form eines Flussdiagramms.

In einem ersten Schritt S1 wird zunächst geprüft, ob die Differenz zwischen der Ausgangsspannung $U_{OUT}$ am Ausgang des Stromzählers 1 und der Ladespannung $U_{LOAD}$ am Übergabepunkt zwischen den beiden Anschlüssen 9, 10 innerhalb eines vorgegebenen Toleranzbereichs $U_{TOL}$ liegt. Falls dies der Fall ist, so erfolgt die Berücksichtigung der Leitungsverluste in einem Schritt S2 gemäß der Vierleitermessung, wie vorstehend beschrieben wurde.

Falls die Differenz zwischen der Ausgangsspannung $U_{OUT}$ und der Ladespannung $U_{LOAD}$ dagegen nicht innerhalb des Toleranzbereiches $U_{TOL}$ liegt, so wird in einem Schritt S3 geprüft, ob eine parametrisierte Messwertkompensation der Leitungsverluste möglich ist, was eine Hinterlegung der Leitungsparameter (z. B. Kabellänge, Kabelquerschnitt, spezifische elektrische Leitfähigkeit des Leitungsmaterials) voraussetzt.

Gegebenenfalls erfolgt dann in einem Schritt S4 eine parametrische Messwertkompensation der Leitungsverluste.

Anderenfalls erfolgt in einem Schritt S6 keine Berücksichtigung der Leitungsverluste.

In einem Schritt S7 erfolgt dann ein regulärer Programmablauf.

Bezugszeichenliste:

| 1 | Stromzähler | |
| 2 | Eingangsseitiger | High-Side-Stromanschluss |
| 3 | Eingangsseitiger | Low-Side-Stromanschluss |
| 4 | Ladequelle | |
| 5 | Ausgangsseitiger | High-Side-Stromanschluss |
| 6 | Ausgangsseitiger | Low-Side-Stromanschluss |
| 7 | Ladekabel | |
| 8 | Stecker | |
| 9, 10 | Anschlüsse des Steckers | |
| 11 | Strommesseinrichtung | |
| 12 | Spannungsmesseinrichtung | |
| 13 | Auswertungseinheit | |

| 14, 15 | Messleitungen im Ladekabel |
| 16, 17 | Spannungsmessanschlüsse |
| 18 | Messleitung im Stromzähler |
| 19 | Recheneinheit |
| 20 | Recheneinheit |
| 21 | Parameterspeicher |
| 22 | Auswahleinrichtung |
| 23 | Recheneinheit |
| $I_{Load}$ | Ladestrom |
| $I_{in}$ | Eingangsstrom von der Ladequelle |
| $P_{LOAD}$ | Ladeleistung |
| $R_{CABLE,HIGH}$ | Leitungswiderstand im Ladekabel auf der High-Side |
| $R_{CABLE,LOW}$ | Leitungswiderstand im Ladekabel auf der Low-Side |
| $R_{LOAD}$ | Verbraucher |
| U1, U2, U3 | Spannungsmesswerte |
| $U_{LOAD}$ | Ladespannung am Übergabepunkt |
| $U_{OUT}$ | Ausgangsspannung am Stromzähler vor dem Ladekabel |
| V1, V2, V3 | Spannungsmesser |

**Patentansprüche**

1. Stromzähler (1) zur Messung eines Stromverbrauchs eines Verbrauchers ($R_{LOAD}$), insbesondere bei einem Ladevorgang eines Elektroautos, mit

a) einem Stromausgang (5, 6), insbesondere mit zwei Stromanschlüssen (5, 6), zum Anschluss eines Verbindungskabels (7), das zu einem Übergabepunkt (9, 10) führt, insbesondere in einem Stecker (8) des Verbindungskabels (7), wobei der Verbraucher ($R_{LOAD}$) über das Verbindungskabel (7) an dem Übergabepunkt (9, 10) mit einem elektrischen Strom ($I_{LOAD}$) gespeist wird, und

b) einer Messschaltung (11, 12) zur Messung mindestens einer elektrischen Verbrauchsgröße des über den Stromausgang (5, 6) zu dem Verbraucher ($R_{LOAD}$) fließenden Stroms ($I_{LOAD}$),

c) wobei der Stromzähler (1) dazu eingerichtet ist, wahlweise in einer von mehreren Betriebsarten betrieben zu werden, wobei sich die Betriebsarten durch die Berücksichtigung von Leitungsverlusten in dem Verbindungskabel (7) unterscheiden,

**dadurch gekennzeichnet durch,**

d) dass eine der Betriebsarten eine erste Betriebsart ist, in der der Stromzähler (1) die Leitungsverluste ($P_{VERLUST,B}$) in dem Verbindungskabel (7) zu dem Verbraucher ($R_{LOAD}$) durch eine Vierleitermessung direkt an dem Übergabepunkt (9, 10) zu dem Verbraucher

($R_{LOAD}$) berücksichtigt, nämlich zum einen durch eine Spannungsmessung an dem Übergabepunkt (9, 10) und zum anderen durch eine Strommessung in dem Stromzähler (1), und

e) **dass** eine der Betriebsarten eine zweite Betriebsart ist, in der die Leitungsverluste ($P_{VERLUST,A}$) in der Verbindungsleitung durch eine parametrisierte Berechnung der Leitungsverluste berücksichtigt werden.

2. Stromzähler (1) nach Anspruch 1, **dadurch gekennzeichnet,**

   a) **dass** die Messschaltung (11, 12) einen ersten Spannungsmesseingang (16) aufweist zur Messung einer ersten Spannung (U1) direkt an dem Übergabepunkt (9) zu dem Verbraucher ($R_{LOAD}$) gegenüber einem Referenzpotential, insbesondere gegenüber dem Potential der High-Side in dem Stromzähler (1), wobei der erste Spannungsmesseingang (16) vorzugsweise über eine erste Messleitung (14) in dem Verbindungskabel (7) mit dem Übergabepunkt (9) verbunden ist,

   b) **dass** die Messschaltung (11, 12) einen zweiten Spannungsmesseingang (17) aufweist zur Messung einer zweiten Spannung (U2) direkt an dem Übergabepunkt (10) zu dem Verbraucher ($R_{LOAD}$) gegenüber dem Referenzpotential, insbesondere gegenüber dem Potential der High-Side in dem Stromzähler (1), wobei der zweite Spannungsmesseingang (17) vorzugsweise über eine zweite Messleitung (15) in dem Verbindungskabel (7) mit dem Übergabepunkt (10) verbunden ist,

   c) **dass** die Messschaltung (11, 12) einen dritten Spannungsmesseingang (18) aufweist zur Messung einer dritten Spannung (U3) in dem Stromzähler (1),

   d) **dass** der dritte Spannungsmesseingang (18) die dritte Spannung (U3) vorzugsweise in dem Stromzähler (1) zwischen der High-Side und der Low-Side misst,

   e) **dass** die erste Messleitung (14) in dem Verbindungskabel (7) die erste Spannung (U1) an dem Übergabepunkt (9) vorzugsweise an der High-Side erfasst,

   f) **dass** die zweite Messleitung (15) in dem Verbindungskabel (7) die zweite Spannung (U2) an dem Übergabepunkt (10) vorzugsweise an der Low-Side erfasst,

   g) **dass** der Stromzähler (1) eine Strommesseinrichtung (11) aufweist zur Messung des Ausgangsstroms ($I_{LOAD}$), der zu dem Verbraucher ($R_{LOAD}$) fließt, und

   h) **dass** der Stromzähler (1) eine Recheneinheit (19) aufweist, welche die Leitungsverluste ($P_{VER\text{-}LUST,B}$) in dem Verbindungskabel (7) in der ersten Betriebsart berechnet in Abhängigkeit von:

   h1) dem Messwert der ersten Spannung (U1),
   h2) dem Messwert der zweiten Spannung (U2),
   h3) dem Messwert der dritten Spannung (U3), und
   h4) dem Messwert des Ausgangsstroms ($I_{LOAD}$).

3. Stromzähler (1) nach Anspruch 2, **dadurch gekennzeichnet,**

   a) **dass** der Stromzähler (1) einen Parameterspeicher (21) aufweist, in dem Leitungsparameter ($\sigma$, L, A) gespeichert sind, die den Leitungswiderstand ($R_{CABLE,HIGH}$, $R_{CABLE,LOW}$) des Verbindungskabels (7) zwischen dem Stromzähler (1) und dem Übergabepunkt (9, 10) wiedergeben, wobei die Leitungsparameter ($\sigma$, L, A) vorzugsweise folgende Parameter des Verbindungskabels (7) umfassen:

   a1) Länge (L) des Verbindungskabels (7),
   a2) spezifische elektrischer Leitfähigkeit ($\sigma$) des Materials des Verbindungskabels (7), und/oder
   a3) Leitungsquerschnitt (A) des Verbindungskabels (7),

   b) **dass** die Recheneinheit den Leitungswiderstand ($R_{CABLE,HIGH}$, $R_{CABLE,LOW}$) in dem Verbindungskabel (7) in der zweiten Betriebsart in Abhängigkeit von dem gemessenen Strom ($I_{LOAD}$) und den gespeicherten Leitungsparametern ($\sigma$, L, A) berechnet, und/oder

   c) **dass** die Recheneinheit (20) die Leitungsverluste ($P_{VERLUST,A}$) in dem Verbindungskabel (7) in der zweiten Betriebsart berechnet in Abhängigkeit von:

   c1) dem gemessenen Ausgangsstrom ($I_{LOAD}$) und
   c2) den gespeicherten Leitungsparametern ($\sigma$, L, A).

4. Stromzähler (1) nach einem der vorhergehenden Ansprüche, **dadurch gekennzeichnet, dass** eine der Betriebsarten eine dritte Betriebsart ist, in der die Leitungsverluste ($P_{VERLUST}$) in dem Verbindungskabel (7) zu dem Verbraucher ($R_{LOAD}$) nicht berücksichtigt werden.

5. Stromzähler (1) nach Anspruch 4, **dadurch gekennzeichnet,**

a) **dass** der Stromzähler (1) eine Auswahleinrichtung (22) aufweist zur Auswahl einer der Betriebsarten,

b) **dass** die Auswahleinrichtung (22) dazu eingerichtet, zu ermitteln, ob an die Spannungsmesseingänge (16, 17) des Stromzählers (1) Messleitungen (14, 15) angeschlossen sind und gegebenenfalls die erste Betriebsart auswählt,

c) **dass** die Auswahleinrichtung (22) dazu eingerichtet, zu ermitteln, ob in dem Parameterspeicher (21) Leitungsparameter ($\sigma$, L, A) gespeichert sind und die zweite Betriebsart auswählt, wenn keine Messleitungen (14, 15) an die Spannungsmesseingänge (16, 17) angeschlossen sind, aber in dem Parameterspeicher (21) Leitungsparameter ($\sigma$, L, A) gespeichert sind, und

d) **dass** die Auswahleinrichtung (22) dazu eingerichtet, die dritte Betriebsart auszuwählen, wenn weder Messleitungen (14, 15) an die Spannungsmesseingänge (16, 17) angeschlossen sind noch Leitungsparameter ($\sigma$, L, A) in dem Parameterspeicher (21) gespeichert sind.

6. Stromzähler (1) nach Anspruch 5, **dadurch gekennzeichnet,**

a) **dass** die Auswahleinrichtung (22) die innerhalb des Stromzählers (1) gemessene Ausgangsspannung ($U_{OUT}$) an dem Stromausgang (5, 6) vergleicht mit der direkt an dem Übergabepunkt (9, 10) gemessenen Ausgangsspannung ($U_{LOAD}$), und

b) **dass** die Auswahleinrichtung (22) die erste Betriebsart mit der Vierleitermessung auswählt, wenn die Differenz zwischen den beiden Ausgangsspannungen ($U_{OUT}$, $U_{LOAD}$) innerhalb eines vorgegebenen Toleranzbereichs liegt.

7. Stromzähler (1) nach Anspruch 6, **dadurch gekennzeichnet,**

a) **dass** die Auswahleinrichtung (22) prüft, ob in dem Parameterspeicher (21) Leitungsparameter ($\sigma$, L, A) hinterlegt sind, und

b) **dass** die Auswahleinrichtung (22) die zweite Betriebsart mit der parametrisierten Berechnung der Leitungsverluste auswählt, falls

b1) die Differenz zwischen den beiden Ausgangsspannungen ($U_{OUT}$, $U_{LOAD}$) nicht innerhalb des vorgegebenen Toleranzbereichs liegt, und

b2) in dem Parameterspeicher (21) Leitungsparameter ($\sigma$, L, A) hinterlegt sind.

8. Stromzähler (1) nach Anspruch 7, **dadurch gekennzeichnet, dass** die Auswahleinrichtung (22) die dritte Betriebsart ohne eine Berücksichtigung der Leitungsverluste ($P_{VERLUST}$) auswählt, falls

a) die Differenz zwischen den beiden Ausgangsspannungen ($U_{OUT}$, $U_{LOAD}$) nicht innerhalb des vorgegebenen Toleranzbereichs liegt, und

b) in dem Parameterspeicher (21) keine Leitungsparameter ($\sigma$, L, A) hinterlegt sind.

9. Stromzählersystem mit

a) dem Stromzähler (1) nach Anspruch 2 oder nach einem der Ansprüche 3-8 wenn abhängig von Anspruch 2, und

b) dem Verbindungkabel, das den Stromzähler (1) mit dem Verbraucher ($R_{LOAD}$) verbindet, insbesondere über einen lösbaren Stecker (8),

c) wobei das Verbindungskabel (7) die beiden Messleitungen (14, 15) enthält, welche die beiden Spannungsmesseingänge (16, 17) des Stromzählers (1) mit dem Übergabepunkt (9, 10) verbinden, um die Ausgangsspannung ($U_{LOAD}$) direkt an dem Übergabepunkt (9, 10) zu messen.

10. Betriebsverfahren für einen Stromzähler (1) nach einem der vorhergehenden Ansprüche, mit den folgenden Schritten:

a) Speisen eines Verbrauchers ($R_{LOAD}$) mit einem elektrischen Strom ($I_{LOAD}$), der durch den Stromzähler (1) über ein Verbindungskabel (7) zu dem Verbraucher ($R_{LOAD}$) fließt, wobei der Verbraucher ($R_{LOAD}$) eine bestimmten Stromaufnahme hat und in dem Verbindungskabel (7) Leitungsverluste ($P_{VERLUST}$) entstehen, und

b) Messung der Stromaufnahme des Verbrauchers ($R_{LOAD}$) durch den Stromzähler (1),

c) Auswahl einer von mehreren Betriebsarten des Stromzählers (1), wobei sich die Betriebsarten durch die Berücksichtigung der Leitungsverluste unterscheiden,

**dadurch gekennzeichnet,**

d) dass eine der Betriebsarten eine erste Betriebsart des Stromzählers (1) ist, wobei der Stromzähler (1) in der ersten Betriebsart die Leitungsverluste ($P_{VERLUST,B}$) in dem Verbindungskabel (7) zu dem Verbraucher ($R_{LOAD}$) durch eine Vierleitermessung direkt an dem Übergabepunkt (9, 10) zu dem Verbraucher ($R_{LOAD}$) berücksichtigt, nämlich zum einen durch eine Spannungsmessung an dem Übergabepunkt (9, 10) und zum anderen durch eine Strommessung in dem Stromzähler (1), und

e) dass eine der Betriebsarten eine zweite Betriebsart ist, in der die Leitungsverluste

($P_{VER-LUST,A}$) in der Verbindungsleitung durch eine parametrisierte Berechnung der Leitungsverluste ($P_{VERLUST,A}$) berücksichtigt werden.

11. Betriebsverfahren nach Anspruch 10, **dadurch gekennzeichnet, dass** eine der Betriebsarten eine dritte Betriebsart ist, in der die Leitungsverluste ($P_{VERLUST}$) in dem Verbindungskabel (7) zu dem Verbraucher ($R_{LOAD}$) nicht berücksichtigt werden.

12. Betriebsverfahren nach Anspruch 11, **gekennzeichnet durch** folgende Schritte:

    a) Messen einer ersten Spannung (U1) direkt an dem Übergabepunkt (9) in Bezug auf ein Referenzpotential, wobei die erste Spannung (U1) **durch** eine Messleitung (14) an dem Übergabepunkt (9) abgegriffen wird und an einem ersten Spannungsmesseingang (16) des Stromzählers (1) gemessen wird,
    b) Messen einer zweiten Spannung (U2) direkt an dem Übergabepunkt (10) in Bezug auf das Referenzpotential, wobei die zweite Spannung (U2) über eine Messleitung (15) direkt an dem Übergabepunkt (10) abgegriffen und an einem zweiten Spannungsmesseingang (17) des Stromzählers (1) gemessen wird, und
    c) Messen einer dritten Spannung (U3) in dem Stromzähler (1), insbesondere zwischen den beiden Stromanschlüssen (5, 6) des Stromzählers (1),
    d) Messen des Stroms ($I_{LOAD}$), der **durch** das Verbindungskabel (7) zu dem Verbraucher ($R_{LOAD}$) fließt,
    e) Berechnen der Leitungsverluste in der ersten Betriebsart in Abhängigkeit von:

        e1) dem Messwert der ersten Spannung (U1),
        e2) dem Messwert der zweiten Spannung (U2),
        e3) dem Messwert der dritten Spannung (U3), und
        e4) dem Messwert des Ausgangsstroms ($I_{LOAD}$).

13. Betriebsverfahren nach Anspruch 12, **gekennzeichnet durch** folgende Schritte für die parametrisierte Berechnung der Leitungsverluste:

    a) Speichern von Leitungsparametern ($\sigma$, L, A) in einem Parameterspeicher (21), wobei die Leitungsparameter ($\sigma$, L, A) den Leitungswiderstand des Verbindungskabels (7) zwischen dem Stromzähler (1) und dem Übergabepunkt (9, 10) zu dem Verbraucher ($R_{LOAD}$) wiedergeben,
    b) Auslesen der Leitungsparameter ($\sigma$, L, A) aus dem Parameterspeicher (21),

    c) Messen des Stroms ($I_{LOAD}$), der von dem Stromzähler (1) **durch** das Verbindungskabel (7) zu dem Verbraucher ($R_{LOAD}$) fließt,
    d) Berechnen der Leitungsverluste ($P_{VERLUST,A}$) in dem Verbindungskabel (7) in Abhängigkeit von den ausgelesenen Leitungsparametern ($\sigma$, L, A) und dem gemessenen Strom ($I_{LOAD}$).

14. Betriebsverfahren nach einem der Ansprüche 10 bis 13, **gekennzeichnet durch** folgende Schritte zur Auswahl einer der Betriebsarten:

    a) Messen einer ersten Ausgangsspannung ($U_{OUT}$) des Stromzählers (1) vor dem Verbindungskabel (7) zu dem Verbraucher ($R_{LOAD}$),
    b) Messen einer zweiten Ausgangsspannung ($U_{LOAD}$) direkt an dem Übergabepunkt (9, 10) zu dem Verbraucher ($R_{LOAD}$),
    c) Vergleichen der beiden Ausgangsspannungen ($U_{OUT}$, $U_{LOAD}$), und
    d) Auswahl der ersten Betriebsart, wenn die Differenz zwischen den beiden Ausgangsspannungen ($U_{OUT}$, $U_{LOAD}$) innerhalb eines vorgegebenen Toleranzbereichs liegt.

15. Betriebsverfahren nach Anspruch 14, **gekennzeichnet durch** folgende Schritte zur Auswahl einer der Betriebsarten:

    a) Prüfen, ob in dem Parameterspeicher (21) Leitungsparameter ($\sigma$, L, A) hinterlegt sind,
    b) Auswahl der zweiten Betriebsart mit der parametrisierten Berechnung der Leitungsverluste, falls

        b1) die Differenz zwischen den beiden Ausgangsspannungen ($U_{OUT}$, $U_{LOAD}$) nicht innerhalb des vorgegebenen Toleranzbereichs liegt, und
        b2) in dem Parameterspeicher (21) Leitungsparameter ($\sigma$, L, A) hinterlegt sind.

16. Betriebsverfahren nach Anspruch 15, wenn abhängig von Anspruch 11, **dadurch gekennzeichnet, dass** die dritte Betriebsart ohne eine Berücksichtigung der Leitungsverluste ausgewählt ist, falls

    a) die Differenz zwischen den beiden Ausgangsspannungen ($U_{OUT}$, $U_{LOAD}$) nicht innerhalb des vorgegebenen Toleranzbereichs liegt, und
    b) in dem Parameterspeicher (21) keine Leitungsparameter ($\sigma$, L, A) hinterlegt sind.

**Claims**

1. Electric meter (1) for measuring the electricity consumption of a load ($R_{LOAD}$), particularly when charging an electric car, with

a) a current output (5, 6), in particular with two current connections (5, 6), for the connection of a connecting cable (7) leading to a transfer point (9, 10), in particular in a plug (8) of the connecting cable (7), the load ($R_{LOAD}$) being supplied with an electric current ($I_{LOAD}$) via the connecting cable (7) at the transfer point (9, 10), and

b) a measuring circuit (11, 12) for measuring at least one electrical consumption variable of the current ($I_{LOAD}$) flowing via the current output (5, 6) to the load ($R_{LOAD}$),

c) wherein the electric meter (1) is adapted to be operated selectively in one of several operating modes, the operating modes differing by taking into account line losses in the connecting cable (7),

**characterized in**

d) that one of the operating modes is a first operating mode in which the electric meter (1) takes into account the line losses ($P_{LOSS,B}$) in the connecting cable (7) to the load ($R_{LOAD}$) by a four-wire measurement directly at the transfer point (9, 10) to the load ($R_{LOAD}$), namely on the one hand by a voltage measurement at the transfer point (9, 10) and on the other hand a current measurement in the electric meter (1), and

e) that one of the operating modes is a second operating mode, in which the line losses ($P_{LOSS,A}$) in the connecting line are taken into account by a parameterized calculation of the line losses.

2. Electric meter (1) according to claim 1, **characterized in**

a) **that** the measuring circuit (11, 12) has a first voltage measurement input (16) for measuring a first voltage (U1) directly at the transfer point (9) to the load ($R_{LOAD}$) with respect to a reference potential, in particular with respect to the potential of the high-side in the electric meter (1), with the first voltage measurement input (16) preferably being connected to the transfer point (9) via a first measuring line (14) in the connecting cable (7),

b) **that** the measuring circuit (11, 12) has a second voltage measurement input (17) for measuring a second voltage (U2) directly at the transfer point (10) to the load ($R_{LOAD}$) with respect to the reference potential, in particular with respect to the potential of the high-side in the electric meter (1), the second voltage measurement input (17) preferably being connected to the transfer point (10) via a second measuring line (15) in the connecting cable (7),

c) **that** the measuring circuit (11, 12) has a third voltage measurement input (18) for measuring a third voltage (U3) in the electric meter (1),

d) **that** the third voltage measurement input (18) measures the third voltage (U3) preferably in the electric meter (1) between the high-side and the low-side,

e) in that the first measuring line (14) in the connecting cable (7) detects the first voltage (U1) at the transfer point (9) preferably at the high-side,

f) **that** the second measuring line (15) in the connecting cable (7) detects the second voltage (U2) at the transfer point (10) preferably at the low side,

g) **that** the electric meter (1) has a current measuring device (11) for measuring the output current ($I_{LOAD}$) which flows to the load ($R_{LOAD}$), and

h) **that** the electric meter (1) comprises a calculation unit (19) which calculates the line losses ($P_{LOSS,B}$) in the connecting cable (7) in the first operating mode as a function of:

h1) the measured value of the first voltage (U1),

h2) the measured value of the second voltage (U2),

h3) the measured value of the third voltage (U3), and

h4) the measured value of the output current ($I_{LOAD}$).

3. Electric meter (1) according to claim 2, **characterized in**

a) **that** the electric meter (1) has a parameter memory (21) in which line parameters ($\sigma$, L, A) are stored which represent the line resistance ($R_{CABLE,HIGH}$, $R_{CABLE,LOW}$) of the connecting cable (7) between the electric meter (1) and the transfer point (9, 10), the line parameters ($\sigma$, L, A) preferably comprising the following parameters of the connecting cable (7):

a1) Length (L) of the connecting cable (7),

a2) specific electrical conductivity ($\sigma$) of the material of the connecting cable (7), and/or

a3) Wire cross section (A) of the connection cable (7),

b) **that** the calculation unit calculates the line resistance ($R_{CABLE,HIGH}$, $R_{CABLE,LOW}$) in the connecting cable (7) in the second operating mode as a function of the measured current ($I_{LOAD}$) and the stored line parameters ($\sigma$, L, A),

and/or

c) **that** the calculation unit (20) calculates the line losses ($P_{LOSS,A}$) in the connecting cable (7) in the second operating mode in dependence on:

    c1) the measured output current ($I_{LOAD}$) and
    c2) the stored line parameters ($\sigma$, L, A).

4. Electric meter (1) according to one of the preceding claims, **characterized in that** one of the operating modes is a third operating mode in which the line losses ($P_{LOSS}$) in the connecting cable (7) to the load ($R_{LOAD}$) are not taken into account.

5. Electric meter (1) according to claim 4, **characterized in**

    a) **that** the electric meter (1) has a selection device (22) for selecting one of the operating modes,
    b) **that** the selection device (22) is adapted to determine whether measuring lines (14, 15) are connected to the voltage measurement inputs (16, 17) of the electric meter (1) and, if so, selects the first operating mode,
    c) **that** the selection device (22) is adapted to determine whether line parameters ($\sigma$, L, A) are stored in the parameter memory (21) and selects the second operating mode if no measurement lines (14, 15) are connected to the voltage measurement inputs (16, 17) but line parameters ($\sigma$, L, A) are stored in the parameter memory (21), and
    d) **that** the selection device (22) is adapted to select the third operating mode if neither measuring lines (14, 15) are connected to the voltage measurement inputs (16, 17) nor line parameters ($\sigma$, L, A) are stored in the parameter memory (21).

6. Electric meter (1) according to claim 5, **characterized in**

    a) **that** the selection device (22) compares the output voltage ($U_{OUT}$) measured inside the electric meter (1) at the current output (5, 6) with the output voltage ($U_{LOAD}$) measured directly at the transfer point (9, 10), and
    b) **that** the selection device (22) selects the first operating mode with the four-wire measurement if the difference between the two output voltages ($U_{OUT}$, $U_{LOAD}$) is within a specified tolerance range.

7. Electric meter (1) according to claim 6, **characterized in**

    a) **that** the selection device (22) checks whether line parameters ($\sigma$, L, A) are stored in the parameter memory (21), and
    b) **that** the selection device (22) selects the second operating mode with the parameterized calculation of the line losses, if

        b1) the difference between the two output voltages ($U_{OUT}$, $U_{LOAD}$) is not within the specified tolerance range, and
        b2) line parameters ($\sigma$, L, A) are stored in the parameter memory (21).

8. Electric meter (1) according to claim 7, **characterized in that** the selection device (22) selects the third operating mode without taking into account the line losses ($P_{LOSS}$) if

    a) the difference between the two output voltages ($U_{OUT}$, $U_{LOAD}$) is not within the specified tolerance range, and
    b) no line parameters ($\sigma$, L, A) are stored in the parameter memory (21).

9. Electric meter system with

    a) the electric meter (1) according to claim 2 or one of claims 3-8 if dependent on claim 2, and
    b) the connection cable that connects the electric meter (1) to the load ($R_{LOAD}$), in particular via a detachable plug (8)
    c) wherein the connecting cable (7) contains the two measuring lines (14, 15) which connect the two voltage measurement inputs (16, 17) of the electric meter (1) to the transfer point (9, 10) in order to measure the output voltage ($U_{LOAD}$) directly at the transfer point (9, 10).

10. Operating method for an electric meter (1) according to one of the preceding claims, with the following steps:

    a) supplying a load ($R_{LOAD}$) with an electric current ($I_{LOAD}$), which flows through the electric meter (1) via a connecting cable (7) to the load ($R_{LOAD}$), the load ($R_{LOAD}$) having a certain current consumption and line losses ($P_{LOSS}$) occurring in the connecting cable (7), and
    b) measurement of the current consumption of the load ($R_{LOAD}$) by the electric meter (1),
    c) selection of one of several operating modes of the electric meter (1), whereby the operating modes differ by the consideration of the line losses,

**characterized in**

    d) that one of the operating modes is a first operating mode of the electric meter (1), wherein the electric meter (1) in the first operating mode takes into account the line losses ($P_{LOSS,B}$) in the connecting cable (7) to the load ($R_{LOAD}$) by means of a four-wire measurement directly at the transfer point (9, 10) to the load ($R_{LOAD}$), namely on the one hand by means of a voltage measurement at the transfer point (9, 10) and on the other hand by means of a current measurement in the electric meter (1), and

e) that one of the operating modes is a second operating mode in which the line losses ($P_{LOSS,A}$) in the connecting line are taken into account by a parameterized calculation of the line losses ($P_{LOSS,A}$).

11. Operating method according to claim 10, **characterized in that one of the operating modes is** a third operating mode in which the line losses ($P_{LOSS}$) in the connecting cable (7) to the load ($R_{LOAD}$) are not taken into account.

12. Operating method according to claim 11, **characterized by** the following steps:

a) measuring a first voltage (U1) directly at the transfer point (9) with respect to a reference potential, the first voltage (U1) being tapped by a measuring line (14) at the transfer point (9) and measured at a first voltage measurement input (16) of the electric meter (1),
b) measuring a second voltage (U2) directly at the transfer point (10) with respect to the reference potential, the second voltage (U2) being tapped via a measuring line (15) directly at the transfer point (10) and measured at a second voltage measurement input (17) of the electric meter (1), and
c) measuring a third voltage (U3) in the electric meter (1), particularly between the two power connections (5, 6) of the electric meter (1),
d) measuring the current ($I_{LOAD}$) flowing through the connecting cable (7) to the load ($R_{LOAD}$),
e) calculation of the line losses in the first operating mode as a function of:

e1) the measured value of the first voltage (U1),
e2) the measured value of the second voltage (U2),
e3) the measured value of the third voltage (U3), and
e4) the measured value of the output current ($I_{LOAD}$).

13. Operating method according to claim 12, **characterized by** the following steps for the parametric calculation of the line losses:

a) storing line parameters ($\sigma$, L, A) in a parameter memory (21), wherein the line parameters ($\sigma$, L, A) represent the line resistance of the connecting cable (7) between the electric meter (1) and the transfer point (9, 10) to the load ($R_{LOAD}$),
b) read out the line parameters ($\sigma$, L, A) from the parameter memory (21),
c) measuring the current ($I_{LOAD}$) flowing from the electric meter (1) through the connecting cable (7) to the load ($R_{LOAD}$),
d) Calculating the line losses ($P_{LOSS,A}$) in the connection cable (7) depending on the read out line parameters ($\sigma$, L, A) and the measured current ($I_{LOAD}$).

14. Operating method according to one of claims 10 to 13, **characterized by** the following steps for selecting one of the operating modes:

a) measuring a first output voltage ($U_{OUT}$) of the electric meter (1) before the connecting cable (7) to the load ($R_{LOAD}$),
b) measuring a second output voltage ($U_{LOAD}$) directly at the transfer point (9, 10) to the load ($R_{LOAD}$),
c) comparing the two output voltages ($U_{OUT}$, $U_{LOAD}$), and
d) selection of the first operating mode if the difference between the two output voltages ($U_{OUT}$, $U_{LOAD}$) is within a specified tolerance range.

15. Operating method according to claim 14, **characterized by** the following steps for selecting one of the operating modes:

a) Checking whether line parameters ($\sigma$, L, A) are stored in the parameter memory (21),
b) selection of the second operating mode with the parameterized calculation of the line losses, if

b1) the difference between the two output voltages ($U_{OUT}$, $U_{LOAD}$) is not within the specified tolerance range, and
b2) are line parameters ($\sigma$, L, A) stored in the parameter memory (21).

16. Operating method according to claim 15 if dependent on claim 11, **characterized in that** the third operating mode is selected without consideration of line losses if

a) the difference between the two output voltages ($U_{OUT}$, $U_{LOAD}$) is not within the specified tolerance range, and
b) no line parameters ($\sigma$, L, A) are stored in the parameter memory (21).

**Revendications**

1. Compteur de courant (1) pour mesurer une consommation électrique d'un consommateur ($R_{LOAD}$), en particulier lors d'un processus de charge d'une voiture électrique, avec

   a) une sortie de courant (5, 6), en particulier avec deux connexions de courant (5, 6), pour la connexion d'un câble de raccordement (7), qui mène à un point de transport (9, 10), en particulier dans une fiche mâle (8) du câble de raccordement (7), dans lequel le consommateur ($R_{LOAD}$) est alimenté en un courant électrique ($I_{LOAD}$) sur le point de transfert (9, 10) par l'intermédiaire du câble de raccordement (7), et
   b) un circuit de mesure (11, 12) pour mesurer au moins une variable de consommation électrique du courant ($I_{LOAD}$) circulant jusqu'au consommateur ($R_{LOAD}$) par l'intermédiaire de la sortie de courant (5, 6),
   c) dans lequel le compteur de courant (1) est mis au point pour fonctionner au choix dans un ou plusieurs modes de fonctionnement, dans lequel les modes de fonctionnement diffèrent par la prise en compte de pertes de conduction dans le câble de raccordement (7),

   caractérisé en ce

   d) qu'un des modes de fonctionnement est un premier mode de fonctionnement, dans lequel le compteur de courant (1) prend en compte les pertes de conduction ($P_{PERTE,B}$) dans le câble de raccordement (7) jusqu'au consommateur ($R_{LOAD}$) par une mesure à quatre fils directement sur le point de transfert (9, 10) jusqu'au consommateur ($R_{LOAD}$), à savoir d'une part par une mesure de tension sur le point de transfert (9, 10) et d'autre part par une mesure de courant dans le compteur de courant (1), et
   e) qu'un des modes de fonctionnement est un deuxième mode de fonctionnement, dans lequel les pertes de conduction ($P_{PERTE,A}$) dans la ligne de raccordement sont prises en compte par un calcul paramétré des pertes de conduction.

2. Compteur de courant (1) selon la revendication 1, **caractérisé en ce**

   a) **que** le circuit de mesure (11, 12) présente une première entrée de mesure de tension (16) pour mesurer une première tension (U1) directement sur le point de transfert (9) jusqu'au consommateur ($R_{LOAD}$) par rapport à un potentiel de référence, en particulier par rapport au potentiel du côté haute tension dans le compteur de courant (1), dans lequel la première entrée de mesure de courant (16) est raccordée au point de transfert (9) de préférence par l'intermédiaire d'une première ligne de mesure (14) dans le câble de raccordement (7),
   b) **que** le circuit de mesure (11, 12) présente une deuxième entrée de mesure de tension (17) pour mesurer une deuxième tension (U2) directement sur le point de transfert (10) jusqu'au consommateur ($R_{LOAD}$) par rapport au potentiel de référence, en particulier par rapport au potentiel du côté haute tension dans le compteur de courant (1), dans lequel la deuxième entrée de mesure de courant (17) est raccordée au point de transfert (10) dans le câble de raccordement (7) de préférence par l'intermédiaire d'une deuxième ligne de mesure (15),
   c) **que** le circuit de mesure (11, 12) présente une troisième entrée de mesure de tension (18) pour mesurer une troisième tension (U3) dans le compteur de courant (1),
   d) **que** la troisième entrée de mesure de tension (18) mesure la troisième tension (U3) de préférence dans le compteur de courant (1) entre le côté haute tension et le côté basse tension,
   e) **que** la première ligne de mesure (14) dans le câble de raccordement (7) détecte la première tension (U1) sur le point de transfert (9) de préférence sur le côté haute tension,
   f) **que** la deuxième ligne de mesure (15) dans le câble de raccordement (7) détecte la deuxième tension (U2) sur le point de transfert (10) de préférence sur le côté basse tension,
   g) **que** le compteur de courant (1) présente un système de mesure de courant (11) pour mesurer le courant de sortie ($I_{LOAD}$) qui circule jusqu'au consommateur ($R_{LOAD}$), et
   h) **que** le compteur de courant (1) présente une unité de calcul (19), laquelle calcule, dans le premier mode de fonctionnement, les pertes de conduction ($P_{PERTE,B}$) dans le câble de raccordement (7) en fonction de :

   h1) la valeur de mesure de la première tension (U1),
   h2) la valeur de mesure de la deuxième tension (U2),
   h3) la valeur de mesure de la troisième tension (U3), et
   h4) la valeur de mesure du courant de sortie ($I_{LOAD}$).

3. Compteur de courant (1) selon la revendication 2, **caractérisé en ce**

   a) **que** le compteur de courant (1) présente une mémoire de paramètres (21), dans laquelle sont mémorisés des paramètres de conduction ($\sigma$, L, A), qui reproduisent la résistance de conduction ($R_{CABLE,HIGH}$, $R_{CABLE,LOW}$) du câble de raccordement (7) entre le compteur de courant (1) et le point de transfert (9, 10), dans lequel les paramètres de conduction ($\sigma$, L, A) comprennent de préférence des paramètres du câble de raccordement (7) qui suivent :

    a1) longueur (L) du câble de raccordement (7),
    a2) conductivité électrique ($\sigma$) spécifique du matériau du câble de raccordement (7), et/ou
    a3) la section transversale de conduction (A) du câble de raccordement (7),

b) **que** l'unité de calcul calcule la résistance de conduction ($R_{CABLE,HIGH}$, $R_{CABLE,LOW}$) dans le câble de raccordement (7) dans le deuxième mode de fonctionnement en fonction du courant ($I_{LOAD}$) mesuré et des paramètres de conduction ($\sigma$, L, A) mémorisés, et/ou
c) **que** l'unité de calcul (20) calcule les pertes de conduction ($P_{PERTE,A}$) dans le câble de raccordement (7) dans le deuxième mode de fonctionnement en fonction :

    c1) du courant de sortie ($I_{LOAD}$) mesuré, et
    c2) des paramètres de conduction ($\sigma$, L, A) mémorisés.

4. Compteur de courant (1) selon l'une quelconque des revendications précédentes, **caractérisé en ce qu'**un des modes de fonctionnement est un troisième mode de fonctionnement, dans lequel les pertes de conduction ($P_{PERTE}$) dans le câble de raccordement (7) jusqu'au consommateur ($R_{LOAD}$) ne sont pas prises en compte.

5. Compteur de courant (1) selon la revendication 4, caractérisé

    a) que le compteur de courant (1) présente un système de sélection (22) pour sélectionner un des modes de fonctionnement,
    b) que le système de sélection (22) est mis au point pour déterminer si des lignes de mesure (14, 15) sont connectées aux entrées de mesure de courant (16, 17) du compteur de courant (1) et sélectionne éventuellement le premier mode de fonctionnement,
    c) que le système de sélection (22) est mis au point pour déterminer si des paramètres de conduction ($\sigma$, L, A) sont mémorisés dans la mémoire de paramètres (21) et sélectionne le deuxième mode de fonctionnement lorsqu'aucune ligne de mesure (14, 15) n'est connectée aux entrées de mesure de courant (16, 17), que toutefois des paramètres de conduction

($\sigma$, L, A) sont mémorisés dans la mémoire de paramètres (21), et
    d) que le système de sélection (22) est mis au point pour sélectionner le troisième mode de fonctionnement lorsqu'aucune ligne de mesure (14, 15) n'est raccordée aux entrées de mesure de tension (16, 17) et que des paramètres de conduction ($\sigma$, L, A) ne sont pas mémorisés dans la mémoire de paramètres (21).

6. Compteur de courant (1) selon la revendication 5, **caractérisé en ce**

    a) **que** le système de sélection (22) compare la tension de sortie ($U_{OUT}$) mesurée à l'intérieur du compteur de courant (1) sur la sortie de courant (5, 6) à la tension de sortie ($U_{LOAD}$) mesurée directement sur le point de transfert (9, 10), et
    b) **que** le système de sélection (22) sélectionne le premier mode de fonctionnement avec la mesure à quatre lignes, lorsque la différence entre les deux tensions de sortie ($U_{OUT}$, $U_{LOAD}$) se situe à l'intérieur d'une plage de tolérances spécifiée.

7. Compteur de courant (1) selon la revendication 6, **caractérisé en ce**

    a) **que** le système de sélection (22) vérifie si les paramètres de conduction ($\sigma$, L, A) sont enregistrés dans la mémoire de paramètres (21), et
    b) **que** le système de sélection (22) sélectionne le deuxième mode de fonctionnement avec le calcul paramétré des pertes de conduction si

        b1) la différence entre les deux tensions de sortie ($U_{OUT}$, $U_{LOAD}$) ne se situe pas à l'intérieur de la plage de tolérances spécifiée, et
        b2) des paramètres de conduction ($\sigma$, L, A) sont enregistrés dans la mémoire de paramètres (21).

8. Compteur de courant (1) selon la revendication 7, **caractérisé en ce que** le système de sélection (22) sélectionne le troisième mode de fonctionnement sans prendre en compte les pertes de conduction ($P_{PERTE}$) si

    a) la différence entre les deux tensions de sortie ($U_{OUT}$, $U_{LOAD}$) ne se situe pas à l'intérieur de la plage de tolérances spécifiée, et
    b) aucun paramètre de conduction ($\sigma$, L, A) n'est enregistré dans la mémoire de paramètres (21).

9. Système à compteur de courant avec

    a) le compteur de courant (1) selon la revendication 2 ou selon l'une quelconque des revendications 3-8 si elles dépendent de la revendication 2, et

b) le câble de raccordement, qui raccorde le compteur de courant (1) au consommateur ($R_{LOAD}$), en particulier par l'intermédiaire d'une fiche mâle (8) amovible,

c) dans lequel le câble de raccordement (7) contient les deux lignes de mesure (14, 15), lesquelles raccordent les deux entrées de mesure de tension (16, 17) du compteur de courant (1) au point de transfert (9, 10) pour mesurer la tension de sortie ($U_{LOAD}$) directement sur le point de transfert (9, 10).

10. Procédé de fonctionnement pour un compteur de courant (1) selon l'une quelconque des revendications précédentes, avec les étapes suivantes :

a) d'alimentation d'un consommateur ($R_{LOAD}$) en un courant électrique ($I_{LOAD}$), qui circule à travers le compteur de courant (1) par l'intermédiaire d'un câble de raccordement (7) jusqu'au consommateur ($R_{LOAD}$), dans lequel le consommateur ($R_{LOAD}$) a une absorption de courant définie et des pertes de conduction ($P_{PERTE}$) apparaissent dans le câble de raccordement (7), et

b) de mesure de l'absorption de courant du consommateur ($R_{LOAD}$) par le compteur de courant (1),

c) de sélection d'un ou de plusieurs modes de fonctionnement du compteur de courant (1), dans lequel les modes de fonctionnement diffèrent par la prise en compte des pertes de conduction,

caractérisé en ce

d) qu'un des modes de fonctionnement est un premier mode de fonctionnement du compteur de courant (1), dans lequel le compteur de courant (1) prend en compte, dans le premier mode de fonctionnement, les pertes de conduction ($P_{PERTE,B}$) dans le câble de raccordement (7) jusqu'au consommateur ($R_{LOAD}$) par une mesure à quatre fils directement sur le point de transfert (9, 10) jusqu'au consommateur ($R_{LOAD}$), à savoir d'une part par une mesure de tension sur le point de transfert (9, 10) et d'autre part par une mesure de courant dans le compteur de courant (1), et

e) qu'un des modes de fonctionnement est un deuxième mode de fonctionnement, dans lequel les pertes de conduction ($P_{PERTE,A}$) dans la ligne de raccordement sont prises en compte par un calcul paramétré des pertes de conduction ($P_{PERTE,A}$).

11. Procédé de fonctionnement selon la revendication 10, **caractérisé en ce qu'**un des modes de fonctionnement est un troisième mode de fonctionnement, dans lequel les pertes de conduction ($P_{PERTE}$) dans le câble de raccordement (7) jusqu'au consommateur ($R_{LOAD}$) ne sont pas prises en compte.

12. Procédé de fonctionnement selon la revendication 11, **caractérisé par** des étapes suivantes :

a) de mesure d'une première tension (U1) directement sur le point de transfert (9) par rapport à un potentiel de référence, dans lequel la première tension (U1) est prélevée par une ligne de mesure (14) sur le point de transfert (9) et est mesurée sur une première entrée de mesure de tension (16) du compteur de courant (1),

b) de mesure d'une deuxième tension (U2) directement sur le point de transfert (10) par rapport au potentiel de référence, dans lequel la deuxième tension (U2) est prélevée par l'intermédiaire d'une ligne de mesure (15) directement sur le point de transfert (10) et est mesurée sur une deuxième entrée de mesure de courant (17) du compteur de courant (1), et

c) de mesure d'une troisième tension (U3) dans le compteur de courant (1), en particulier entre les deux connexions de courant (5, 6) du compteur de courant (1),

d) de mesure du courant ($I_{LOAD}$), qui circule à travers le câble de raccordement (7) jusqu'au consommateur ($R_{LOAD}$),

e) de calcul des pertes de conduction dans le premier mode de fonctionnement en fonction de :

e1) la valeur de mesure de la première tension (U1),
e2) de la valeur de mesure de la deuxième tension (U2),
e3) de la valeur de mesure de la troisième tension (U3), et
e4) de la valeur de mesure du courant de sortie ($I_{LOAD}$).

13. Procédé de fonctionnement selon la revendication 12, **caractérisé par** des étapes suivantes pour le calcul paramétré des pertes de conduction :

a) la mémorisation de paramètres de conduction ($\sigma$, L, A) dans une mémoire de paramètres (21), dans lequel les paramètres de conduction ($\sigma$, L, A) reproduisent la résistance de conduction du câble de raccordement (7) entre le compteur de courant (1) et le point de transfert (9, 10) jusqu'au consommateur ($R_{LOAD}$),

b) la lecture des paramètres de conduction ($\sigma$, L, A) depuis la mémoire de paramètres (21),

c) de mesure du courant ($I_{LOAD}$), qui circule depuis le compteur de courant (1) à travers le câble de raccordement (7) jusqu'au consommateur ($R_{LOAD}$),
d) de calcul des pertes de conduction ($P_{PERTE,A}$) dans le câble de raccordement (7) en fonction des paramètres de conduction ($\sigma$, L, A) lus et du courant ($I_{LOAD}$) mesuré.

14. Procédé de fonctionnement selon l'une quelconque de revendications 10 à 13, **caractérisé par** des étapes qui suivent pour sélectionner un des modes de fonctionnement :

   a) la mesure d'une première tension de sortie ($U_{OUT}$) du compteur de courant (1) avant le câble de raccordement (7) jusqu'au consommateur ($R_{LOAD}$),
   b) la mesure d'une deuxième tension de sortie ($U_{LOAD}$) directement sur le point de transfert (9, 10) jusqu'au consommateur ($R_{LOAD}$),
   c) de comparaison des deux tensions de sortie ($U_{OUT}$, $U_{LOAD}$),
   d) de sélection du premier mode de fonctionnement lorsque la différence entre les deux tensions de sortie ($U_{OUT}$, $U_{LOAD}$) se situe à l'intérieur d'une plage de tolérances spécifiée.

15. Procédé de fonctionnement selon la revendication 14, **caractérisé par** des étapes suivantes pour sélectionner un des modes de fonctionnement :

   a) de vérification si des paramètres de conduction ($\sigma$, L, A) sont enregistrés dans la mémoire de paramètre (21),
   b) de sélection du deuxième mode de fonctionnement avec le calcul paramétré des pertes de conduction si

      b1) la différence entre les deux tensions de sortie ($U_{OUT}$, $U_{LOAD}$) ne se situe pas à l'intérieur de la plage de tolérances spécifiée, et
      b2) des paramètres de conduction ($\sigma$, L, A) sont enregistrés dans la mémoire de paramètres (21).

16. Procédé de fonctionnement selon la revendication 15, si elle dépend de la revendication 11, **caractérisé en ce que** le troisième mode de fonctionnement est sélectionné sans prendre en compte les pertes de conduction si

   a) la différence entre les deux tensions de sortie ($U_{OUT}$, $U_{LOAD}$) ne se situe pas à l'intérieur de la plage de tolérances spécifiée, et
   b) aucun paramètre de conduction ($\sigma$, L, A) n'est enregistré dans la mémoire de paramètres (21).

Fig. 1
Stand der Technik

Fig. 2

Fig. 3

Fig. 4

Start → S1: $U_{OUT} - U_{LOAD} < U_{TOL}$?
- ja → S2: Kompensation 4-Leitermessung
- nein → S3: Komp. Par != 0
  - ja → S4: Parametrische Kompensation
  - nein → S6: Kompensationslose Messung

→ S7: Regulärer Programmablauf

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102012102633 A1
- DE 102014226397 A1
- US 10084266 B1
- US 2012112735 A1
- EP 2579417 A1
- US 2013300429 A1